# EUROPEAN PATENT APPLICATION

(11) **EP 4 468 359 A1**
(43) Date of publication of application: **27.11.2024**
(21) Application number: 22928924.4
(22) Date of filing: 09.12.2022
(51) Int. Cl.: H01L 27/148, H04N 25/00

(54) **SOLID-STATE IMAGING ELEMENT**

(30) Priority: 24.02.2022 JP 2022026499
(71) Applicant: Hamamatsu Photonics K.K., Hamamatsu-shi, Shizuoka 435-8558 (JP)
(72) Inventor: TANAKA, Fumiya, Hamamatsu-shi, Shizuoka 435-8558 (JP); YAMADA, Atsunori, Hamamatsu-shi, Shizuoka 435-8558 (JP); TAKAGI, Shin-ichiro, Hamamatsu-shi, Shizuoka 435-8558 (JP); YONETA, Yasuhito, Hamamatsu-shi, Shizuoka 435-8558 (JP)
(74) Representative: Hoffmann Eitle
(86) International application number: PCT/JP2022/045530
(87) International publication number: WO 2023/162407

(57) **Abstract**

A solid-state imaging element includes a semiconductor substrate, a first element unit formed on the semiconductor substrate, and a second element unit formed on the semiconductor substrate. The first element unit includes a light receiving part that generates charges in response to incidence of light, and a transfer part that transfers a charges. The transfer part is disposed over a charge transfer region of the semiconductor substrate, and includes a first transfer electrode and a second transfer electrode aligned in a transfer direction of the charges, and a discharge gate electrode disposed over a charge discharge region of the semiconductor substrate along the charge transfer region. The first transfer electrode is formed as a first layer, and the second transfer electrode and the discharge gate electrode are formed as second layers. The first transfer electrode includes a portion overlapping a part of the second transfer electrode and a portion overlapping a part of the discharge gate electrode. The second transfer electrode is spaced apart from the discharge gate electrode.

## Description

### Technical Field

The present disclosure relates to a solid-state imaging element.

### Background Art

Non Patent Literatures 1 and 2 describe a monolithic CCD-CMOS as a solid-state imaging element of the related art. The monolithic CCD-CMOS is a solid-state imaging element in which a CCD unit that generates charges in response to incidence of light and transfers the charges and a CMOS unit that processes a digital signal corresponding to the charges are formed on a single semiconductor substrate.

### Citation List

### Non Patent Literature

Non Patent Literature 1: Lee, Hyun Jung. "Charge-Coupled CMOS TDI Imager." Proceedings of the 2017 International Image Sensor Workshop, Hiroshima, Japan. Vol. 30. 2017.
Non Patent Literature 2: De Moor, Piet, et al. "Enhanced time delay integration imaging using embedded CCD in CMOS technology." 2014 IEEE International Electron Devices Meeting. IEEE, 2014.

### Summary of Invention

### Technical Problem

In the monolithic CCD-CMOS described in Non Patent Literatures 1 and 2, in the CCD unit, a plurality of transfer electrodes and discharge gate electrodes are disposed in the same layer, and gaps are formed between adjacent transfer electrodes and between each transfer electrode and the discharge gate electrode. Thus, the charges may be trapped in a region corresponding to each gap in the semiconductor substrate, and the transfer of the charges and the discharge of the charges may not be appropriately performed.

An object of the present disclosure is to provide a solid-state imaging element capable of securing appropriate characteristics.

### Solution to Problem

A solid-state imaging element according to an aspect of the present disclosure includes a semiconductor substrate, a first element unit formed on the semiconductor substrate, and a second element unit formed on the semiconductor substrate, the first element unit includes a light receiving part configured to generate charges in response to incidence of light, and a transfer part configured to transfer charges, the second element unit is configured to perform at least one of transmission of a signal to the first element unit and reception of a signal from the first element unit, the transfer part includes a first transfer electrode and a second transfer electrode that are disposed over a charge transfer region of the semiconductor substrate, and are aligned in a transfer direction of the charges, and a discharge gate electrode that is disposed over a charge discharge region of the semiconductor substrate along the charge transfer region, the first transfer electrode is formed as a first layer, the second transfer electrode and the discharge gate electrode are formed as second layers different from the first layer, as viewed from a thickness direction of the semiconductor substrate, the first transfer electrode includes a portion overlapping a part of the second transfer electrode and a portion overlapping a part of the discharge gate electrode, and as viewed from the thickness direction of the semiconductor substrate, the second transfer electrode is spaced apart from the discharge gate electrode.

In the solid-state imaging element, as viewed from the thickness direction of the semiconductor substrate, the first transfer electrode includes the portion overlapping the part of the second transfer electrode and the portion overlapping the part of the discharge gate electrode. As a result, it is less likely to form the gaps between the first transfer electrode and the second transfer electrode and between the first transfer electrode and the discharge gate electrode as viewed from the thickness direction of the semiconductor substrate. Thus, in the charge transfer region and the charge discharge region, it is possible to suppress generation of a region where charges are trapped, and it is possible to appropriately perform the transfer of the charges and the discharge of the charges. In addition, in the solid-state imaging element in which the first element unit and the second element unit are formed on the single semiconductor substrate, in a case where the layer structure of the electrodes included in the first element unit is three or more layers, it is difficult to form the electrodes and the like included in the second element unit with high accuracy. In contrast, in the solid-state imaging element, since the layer structure of the first transfer electrode, the second transfer electrode, and the discharge gate electrode included in the first element unit has two layers, the electrode and the like included in the second element unit can be formed with high accuracy. As described above, according to the solid-state imaging element, appropriate characteristics can be secured.

In the solid-state imaging element according to the aspect of the present disclosure, the part of the second transfer electrode and the part of the discharge gate electrode may be positioned on the same side with respect to the first transfer electrode in the thickness direction of the semiconductor substrate. According to this configuration, the layer structure of the first transfer electrode, the second transfer electrode, and the discharge gate electrode included in the first element unit can be formed into two layers with a simple structure.

In the solid-state imaging element according to the aspect of the present disclosure, the transfer part may further include an insulating layer extending as the same layer between the first transfer electrode and the part of the second transfer electrode and between the first transfer electrode and the part of the discharge gate electrode. According to this configuration, the layer structure of the first transfer electrode, the second transfer electrode, and the discharge gate electrode included in the first element unit can be formed into two layers with a simple structure.

In the solid-state imaging element according to the aspect of the present disclosure, the charge discharge region may include a drain region, and the discharge gate electrode and the drain region extend in the transfer direction. According to this configuration, surplus charges in the charge transfer region can be appropriately discharged to the drain region, and an anti-blooming property of the solid-state imaging element can be improved.

In the solid-state imaging element according to the aspect of the present disclosure, the first element unit may include an amplifier part configured to convert the charge transferred by the transfer part into an analog signal, and the second element unit includes a conversion part configured to convert the analog signal into a digital signal. According to this configuration, the solid-state imaging element can convert the analog signal into the digital signal that is hardly influenced by noise.

In the solid-state imaging element according to the aspect of the present disclosure, the charge transfer region may include a first transfer region and a second transfer region having an impurity concentration different from an impurity concentration of the first transfer region, the first transfer electrode may be disposed over the first transfer region, and the second transfer electrode may be disposed over the second transfer region. According to this configuration, a two-phase driving method can be used as a charge transfer method in the transfer part, and an operation of the first element unit can be realized with a control voltage of a minimum number of phases (two phases).

### Advantageous Effects of Invention

According to the present disclosure, it is possible to provide the solid-state imaging element capable of securing appropriate characteristics.

### Brief Description of Drawings

FIG. 1 is a schematic plan view of a solid-state imaging element of a first embodiment.
FIG. 2 is a schematic sectional view of the solid-state imaging element illustrated in FIG. 1.
FIG. 3 is a partial sectional view taken along line III-III illustrated in FIG. 1.
FIG. 4 is a partial sectional view taken along line IV-IV illustrated in FIG. 1.
FIG. 5 is a partial plan view in FIGS. 3 and 4.
FIG. 6 is a sectional view of the solid-state imaging element illustrated in FIG. 1.
FIG. 7 is a sectional view of a first element unit of a solid-state imaging element of a second embodiment.
FIG. 8 is a sectional view of a first element unit of a solid-state imaging element according to a third embodiment.

### Description of Embodiments

Hereinafter, embodiments of the present disclosure will be described in detail with reference to the drawings. In the drawings, the same or corresponding portions are denoted by the same reference signs, and redundant portions are omitted.

### [First Embodiment]

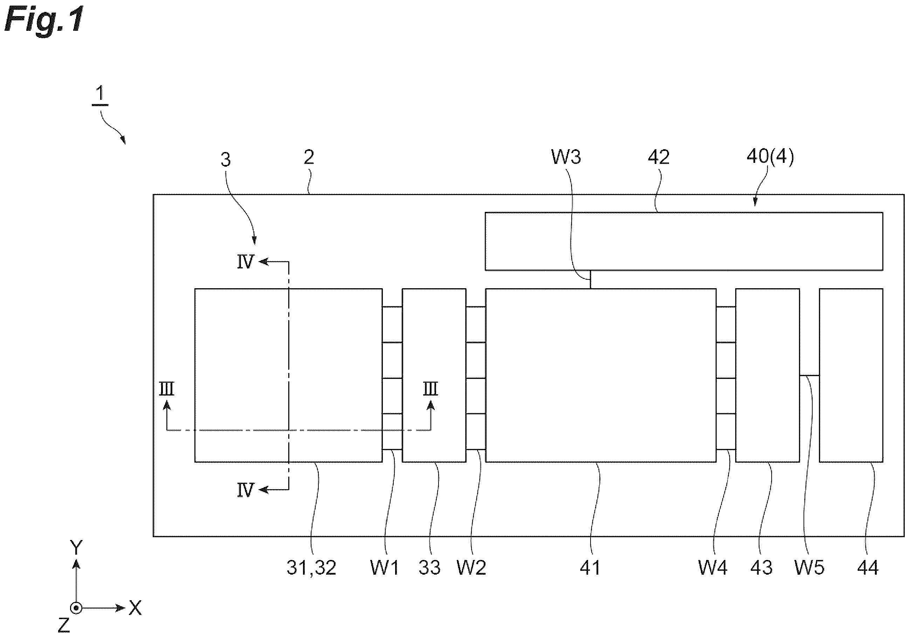

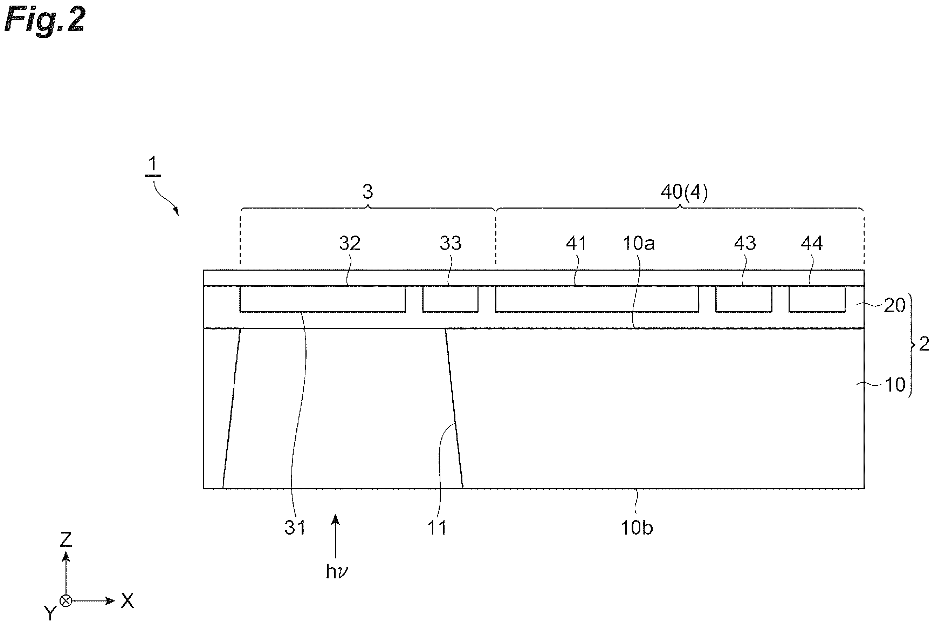

As illustrated in FIGS. 1 and 2, a solid-state imaging element 1 includes a semiconductor substrate 2, a first element unit 3, and a second element unit 4. The first element unit 3 and the second element unit 4 are formed on a single semiconductor substrate 2. The second element unit 4 is configured to receive a signal from the first element unit 3. The first element unit 3 is, for example, a charge coupled device (CCD) unit, and the second element unit 4 is, for example, a complementary metal oxide semiconductor (CMOS) unit. That is, the solid-state imaging element 1 is, for example, a monolithic CCD-CMOS. Hereinafter, a thickness direction of the semiconductor substrate 2 is referred to as a Z direction, one direction perpendicular to the Z direction is referred to as an X direction, and a direction perpendicular to both directions of the Z direction and the X direction is referred to as a Y direction.

The semiconductor substrate 2 has, for example, a rectangular shape as viewed from the Z direction. A longitudinal direction of the semiconductor substrate 2 is along the X direction. The semiconductor substrate 2 includes a base portion 10 and a semiconductor layer 20.

The base portion 10 has a P-type conductivity type. The base portion 10 is, for example, a silicon substrate. The base portion 10 has a surface 10a and a surface 10b perpendicular to the Z direction. The surface 10b has an opened recessed portion 11. The recessed portion 11 has, for example, a quadrangular frustum shape expanding from the surface 10a toward the surface 10b. In the present embodiment, the recessed portion 11 penetrates the base portion 10. Accordingly, the semiconductor layer 20 is exposed at a bottom portion of the recessed portion 11. The recessed portion 11 is formed by, for example, etching. A thickness of the portion of the base portion 10 where the recessed portion 11 is not formed is, for example, about 300 µm.

The semiconductor layer 20 is formed on the surface 10a of the base portion 10. The semiconductor layer 20 is, for example, an epitaxial growth layer containing silicon. A thickness of the semiconductor layer 20 is, for example, about 10 µm. The first element unit 3 and the second element unit 4 are formed in the semiconductor layer 20.

The first element unit 3 includes a light receiving part 31, a transfer part 32, and an amplifier part 33. The light receiving part 31 generates charges in response to incidence of light hv. The light receiving part 31 is formed at a position overlapping the recessed portion 11 in the Z direction. The light hv is incident on the light receiving part 31 from the surface 10b side of the base portion 10 via the recessed portion 11. The light receiving part 31 includes, for example, a plurality of pixels aligned two-dimensionally along the X direction and the Y direction. The transfer part 32 transfers the charges generated in the light receiving part 31. The transfer part 32 transfers the charges along the X direction for each pixel array extending along the X direction. The amplifier part 33 converts the charge transferred by the transfer part 32 into an analog signal (signal voltage). The amplifier part 33 is electrically connected to the transfer part 32 by a wiring W1. The analog signal converted by the amplifier part 33 is transmitted to the second element unit 4.

The second element unit 4 includes a signal processing part 40. The signal processing part 40 processes a digital signal corresponding to the charge transferred by the transfer part 32. The signal processing part 40 includes a conversion part 41, a drive part 42, a multiplexer part 43, and an output part 44. The conversion part 41 converts the analog signal received from the first element unit 3 into a digital signal. The conversion part 41 is electrically connected to the amplifier part 33 by a wiring W2. The drive part 42 generates a signal for driving the conversion part 41. The drive part 42 includes, for example, a phase locked loop (PLL) and a timing generator. The drive part 42 is electrically connected to the conversion part 41 by a wiring W3. The multiplexer part 43 bundles a plurality of digital signals converted by the conversion part 41 to generate one digital signal. The multiplexer part 43 is electrically connected to the conversion part 41 by a wiring W4. The output part 44 converts the digital signal from the multiplexer part 43 into a differential voltage signal and outputs the differential voltage signal to an outside. The output part 44 includes, for example, a low voltage differential signaling (LVDS) part. The output part 44 is electrically connected to the multiplexer part 43 by a wiring W5.

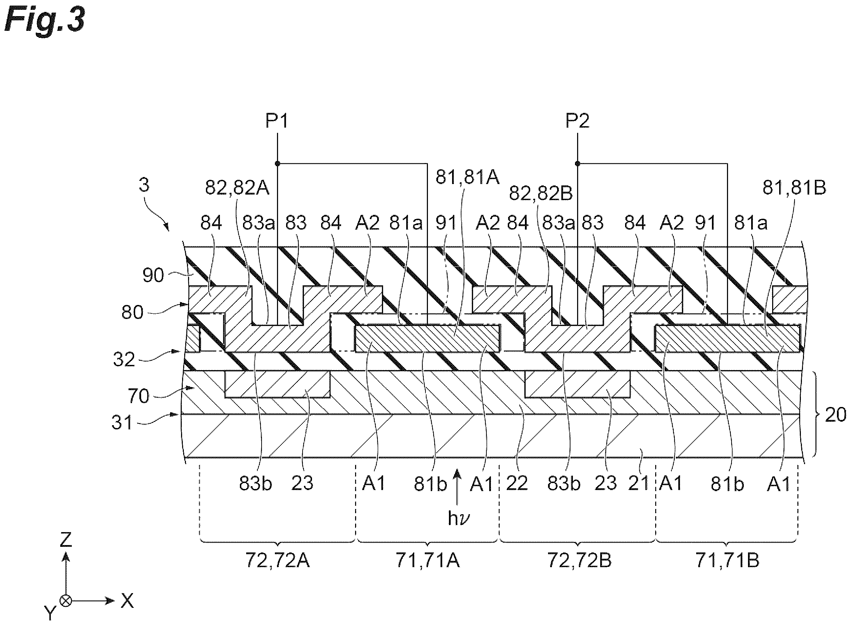

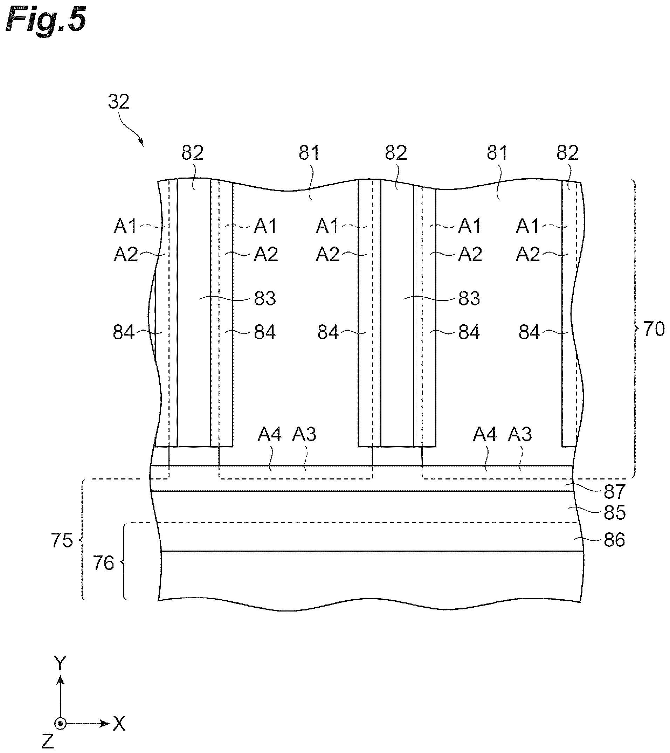

As illustrated in FIGS. 3, 4, and 5, the semiconductor layer 20 includes a semiconductor region 21, a semiconductor region 22, and a plurality of semiconductor regions 23. The semiconductor region 21 has a P-type conductivity type, and is formed on the surface 10a of the base portion 10. The semiconductor region 22 has an N-type conductivity type, and is formed on the semiconductor region 21. Each semiconductor region 23 has an N⁻-type conductivity type. The "N⁻-type" means that a concentration of an N-type impurity is lower than that of the "N-type". Each semiconductor region 23 is formed within the semiconductor region 22 along a surface of the semiconductor region 22 opposite to the semiconductor region 21.

The light receiving part 31 includes a PN junction region formed in the semiconductor layer 20. Specifically, the PN junction region is formed at a boundary portion between the semiconductor region 21 and the semiconductor region 22. When the light hv is incident on the PN junction region formed in the semiconductor layer 20, the charges are generated.

The transfer part 32 includes a charge transfer region 70, a charge discharge region 75, a plurality of transfer electrodes 80, a discharge gate electrode 85, and a plurality of insulating layers 90. The charge transfer region 70 is formed within the semiconductor layer 20. The charge transfer region 70 includes the semiconductor region 22 and the semiconductor region 23, and transfers the charge generated in the light receiving part 31. The charge transfer region 70 includes a plurality of first transfer regions 71 and a plurality of second transfer regions 72. The first transfer region 71 of the present embodiment is a region positioned between two semiconductor regions 22 aligned in the X direction in the semiconductor region 23, and overlaps a first transfer electrode 81 to be described later in the Z direction. The first transfer region 71 does not include the semiconductor region 23. The second transfer region 72 of the present embodiment is a region including the semiconductor region 23, and overlaps a second transfer electrode 82 to be described later in the Z direction. The first transfer region 71 and the second transfer region 72 are alternately aligned in a transfer direction of the charges (X direction). The semiconductor region 22 has an N-type conductivity type, and the semiconductor region 23 has an N⁻-type conductivity type. Accordingly, an impurity concentration of the first transfer region 71 not including the semiconductor region 23 is different from an impurity concentration of the second transfer region 72 including the semiconductor region 23. Specifically, the impurity concentration of the first transfer region 71 is higher than the impurity concentration of the second transfer region 72.

The plurality of transfer electrodes 80 are disposed over the charge transfer region 70 and includes a plurality of first transfer electrodes 81 and a plurality of second transfer electrodes 82. The first transfer electrode 81 and the second transfer electrode 82 are made of, for example, polysilicon. The first transfer electrode 81 and the second transfer electrode 82 are electrodes that transfer the charges generated in the light receiving part 31 in the X direction. The first transfer electrode 81 and the second transfer electrode 82 transfer the charges for each pixel array extending along the X direction. The first transfer electrode 81 is disposed over the first transfer region 71, and the second transfer electrode 82 is disposed over the second transfer region 72. The first transfer electrode 81 and the second transfer electrode 82 are alternately aligned in the transfer direction of the charges (X direction).

The first transfer electrode 81 has, for example, a rectangular shape as viewed from the Z direction. A longitudinal direction of the first transfer electrode 81 is along the Y direction. A shape of the first transfer electrode 81 as viewed from the Z direction is not limited. The first transfer electrode 81 has a flat plate shape along the X direction and the Y direction. The first transfer electrode 81 has a pair of surfaces 81a and 81b opposed to each other in the Z direction. The surfaces 81a and 81b are along the X direction and the Y direction. The surface 81a is positioned farther from the semiconductor substrate 2 than the surface 81b. As viewed from the Z direction, the first transfer electrode 81 has a pair of overlapping portions A1 overlapping a part (overlapping portion A2) of the second transfer electrode 82. The pair of overlapping portions A1 is positioned at both end portions of the first transfer electrode 81 in the X direction.

The second transfer electrode 82 has, for example, a rectangular shape as viewed from the Z direction. A longitudinal direction of the second transfer electrode 82 is along the Y direction. A shape of the second transfer electrode 82 as viewed from the Z direction is not limited. The second transfer electrode 82 includes a first portion 83 and a pair of second portions 84. The first portion 83 has a flat shape along the X direction and the Y direction. The first portion 83 is spaced apart from the semiconductor layer 20 by the same distance as a distance from the semiconductor layer 20 to the first transfer electrode 81. The first portion 83 has a pair of surfaces 83a and 83b opposed to each other in the Z direction. The surface 83b is positioned closer to the semiconductor layer 20 than the surface 83a, and is at the same height as the surface 81b of the first transfer electrode 81. The second portion 84 is positioned farther from the semiconductor layer 20 than the first portion 83 in the Z direction. The second portion 84 is formed to be bent from the Z direction to the X direction in XZ sectional view. The second portion 84 has a portion along the Y direction and the Z direction and a portion along the X direction and the Y direction. The portion of the second portion 84 along the Y direction and the Z direction is continuous with corresponding an end portion of both end portions of the first portion 83 in the X direction. The second portion 84 has an overlapping portion A2. The overlapping portion A2 is a portion overlapping the overlapping portion A1 of the first transfer electrode 81 as viewed from the Z direction. The overlapping portion A2 is positioned on the surface 81a side with respect to the first transfer electrode 81 in the Z direction. As viewed from the Z direction, a gap is not formed between the first transfer electrode 81 and the second transfer electrode 82.

The charge discharge region 75 is a region where the charges are discharged from the charge transfer region 70. The charge discharge region 75 is along the charge transfer region 70 and is adjacent to the charge transfer region 70 in the Y direction. The charge discharge region 75 includes a drain region 76. The drain region 76 is a region from which surplus charges within the charge transfer region 70 are discharged. The drain region 76 extends in the X direction. The drain region 76 has an N⁺-type conductivity type. The "N⁺-type" means that a concentration of an N-type impurity is higher than that of the "N-type".

The discharge gate electrode 85 is disposed over the charge discharge region 75. The discharge gate electrode 85 extends in the X direction. That is, the discharge gate electrode 85 and the drain region 76 extend in the same direction. The discharge gate electrode 85 has, for example, a rectangular shape as viewed from the Z direction. A longitudinal direction of the discharge gate electrode 85 is along the X direction. A shape of the discharge gate electrode 85 as viewed from the Z direction is not limited. The discharge gate electrode 85 includes a first portion 86 and a second portion 87. The first portion 86 has a flat shape along the X direction and the Y direction. The first portion 86 is spaced apart from the semiconductor layer 20 by the same distance as the distance from the semiconductor layer 20 to the first transfer electrode 81. Of a pair of surfaces 86a and 86b opposed to each other in the Z direction of the first portion 86, the surface 86b closer to the semiconductor layer 20 is at the same height as the surface 81b of the first transfer electrode 81. The first portion 86 overlaps the drain region 76 in the Z direction. The second portion 87 is positioned farther from the semiconductor layer 20 than the first portion 86 in the Z direction. The second portion 87 is formed to be bent from the Z direction to the Y direction in YZ sectional view. The second portion 87 has a portion along the X direction and the Z direction and a portion along the X direction and the Y direction. The portion of the second portion 87 along the X direction and the Z direction is continuous with an end portion on the charge transfer region 70 side of both end portions of the first portion 86 in the Y direction.

As viewed from the Z direction, the first transfer electrode 81 has an overlapping portion A3 overlapping a part (overlapping portion A4) of the discharge gate electrode 85. The overlapping portion A3 is positioned at an end portion on the charge discharge region 75 side of both end portions of the first transfer electrode 81 in the Y direction. The second portion 87 of the discharge gate electrode 85 has an overlapping portion A4. The overlapping portion A4 is a portion overlapping the overlapping portion A3 of the first transfer electrode 81 as viewed from the Z direction. The overlapping portion A4 is positioned on the surface 81a side with respect to the first transfer electrode 81 in the Z direction. Accordingly, the overlapping portion A2 of the second transfer region 72 and the overlapping portion A4 of the discharge gate electrode 85 are positioned on the same side with respect to the first transfer electrode 81 in the Z direction. As viewed from the Z direction, a gap is not formed between the first transfer electrode 81 and the discharge gate electrode 85. The discharge gate electrode 85 extends over the plurality of first transfer electrodes 81 aligned spaced apart in the X direction. That is, the common discharge gate electrode 85 extends to overlap the plurality of first transfer electrodes 81.

As viewed from the Z direction, the second transfer electrode 82 is spaced apart from the discharge gate electrode 85. That is, as viewed from the Z direction, a gap is formed between the second transfer electrode 82 and the discharge gate electrode 85. In the present embodiment, the second transfer electrode 82 is spaced apart from the discharge gate electrode 85 in the Y direction. As viewed from the Z direction, a width of the gap between the discharge gate electrode 85 and the second transfer electrode 82 in the Y direction is smaller than an interval between the first transfer electrodes 81 adjacent in the X direction. The second transfer electrode 82 is not in contact with the discharge gate electrode 85 and does not overlap the discharge gate electrode 85 in the Z direction.

A layer structure of the electrodes (first transfer electrode 81, second transfer electrode 82, and discharge gate electrode 85) included in the solid-state imaging element 1 has a two-layer structure. In the solid-state imaging element 1, the first transfer electrode 81 is formed as a first layer, and the second transfer electrode 82 and the discharge gate electrode 85 are formed as second layers different from the first layer. The "first layer" and the "second layer" correspond to timings at which layers are formed in ae manufacturing process of the solid-state imaging element 1. Specifically, the layer formed as the first layer is a layer that cannot be formed simultaneously with the layer formed as the second layer. In the present embodiment, since a part of the first transfer electrode 81 overlaps the second transfer electrode 82 and the discharge gate electrode 85, the first transfer electrode 81 cannot be formed simultaneously with the second transfer electrode 82 and the discharge gate electrode 85. The first transfer electrode 81 is formed before the formation of the second transfer electrode 82 and the discharge gate electrode 85. In addition, layers formed as the same layer can be simultaneously formed. In the present embodiment, the second transfer electrode 82 and the discharge gate electrode 85 formed as the same second layer are simultaneously formed after the first transfer electrode 81 is formed. The layers formed as the same layer may be layers that can be simultaneously formed, and may not necessarily be simultaneously formed. For example, in the present embodiment, the second transfer electrode 82 and the discharge gate electrode 85 may be formed at different timings.

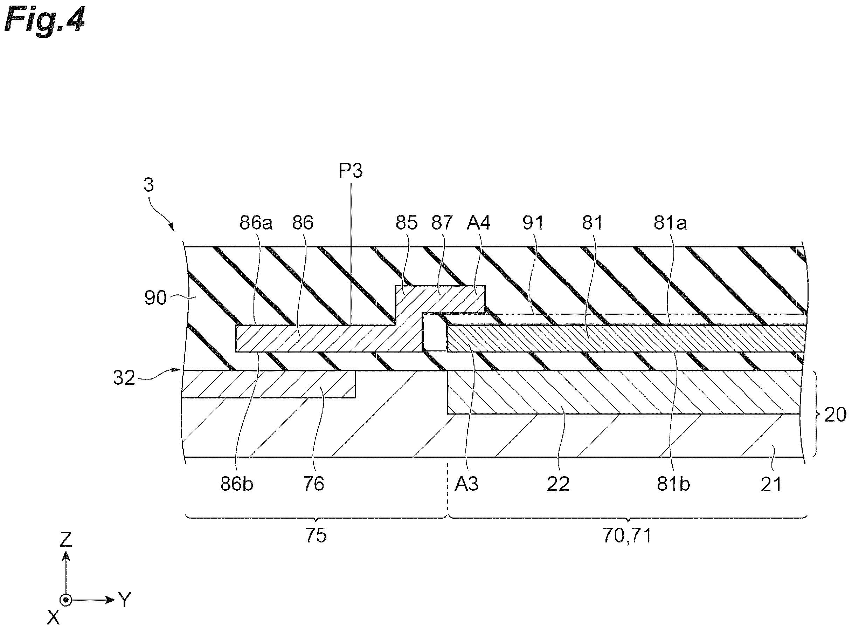

The plurality of insulating layers 90 are formed on the semiconductor layer 20. Each insulating layer 90 is a layer made of, for example, silicon oxide. The silicon oxide is, for example, SiO₂. A thickness of each insulating layer 90 is, for example, about several tens to several hundreds nm. The plurality of insulating layers 90 electrically separate the first transfer electrode 81, the second transfer electrode 82, and the discharge gate electrode 85 from each other. In FIGS. 3 and 4, only an insulating layer 91 among the plurality of insulating layers 90 is indicated by a dashed double-dotted line for the sake of convenience in description. The insulating layer 91 extends, as the same layer, between the overlapping portion A1 of the first transfer electrode 81 and the overlapping portion A2 of the second transfer electrode 82 and between the overlapping portion A3 of the first transfer electrode 81 and the overlapping portion A4 of the discharge gate electrode 85. The insulating layer 91 is continuously formed along the surface 81a of the first transfer electrode 81 to extend from between the overlapping portion A1 and the overlapping portion A2 to between the overlapping portion A3 and the overlapping portion A4.

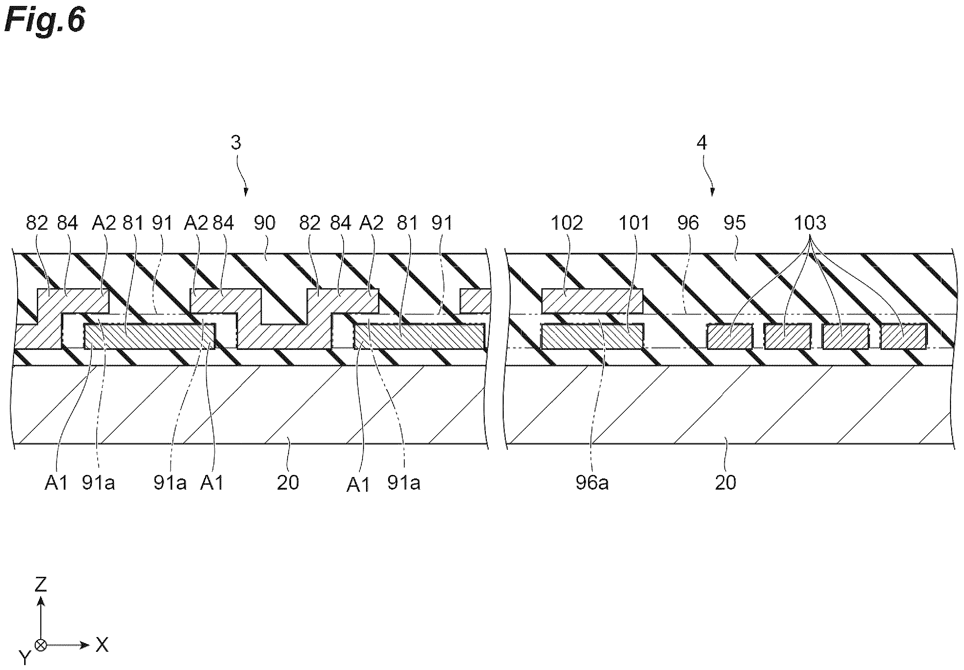

A relationship between a layer structure of electrodes of the first element unit 3 and a layer structure of electrodes of the second element unit 4 will be described with reference to FIG. 6. As illustrated in FIG. 6, the second element unit 4 includes a first electrode 101, a second electrode 102, and a plurality of third electrodes 103 formed on the semiconductor layer 20. The first electrode 101, the second electrode 102, and the plurality of third electrodes 103 are included in the signal processing part 40 (see FIG. 1) of the second element unit 4, and are included, for example, in any of the conversion part 41, the drive part 42, the multiplexer part 43, and the output part 44. The first electrode 101, the second electrode 102, and the plurality of third electrodes 103 are made of, for example, polysilicon. The first electrode 101 and the second electrode 102 overlap each other in the Z direction, and constitute, for example, a capacitor. The plurality of third electrodes 103 are aligned in the X direction, and constitute, for example, a gate electrode of a field effect transistor (FET).

The first electrode 101 is formed as the first layer. That is, the first electrode 101 can be formed simultaneously with the first transfer electrode 81 of the first element unit 3. The first electrode 101 is spaced apart from the semiconductor layer 20 by the same distance as the distance from the semiconductor layer 20 to the first transfer electrode 81. The second electrode 102 is formed as a second layer. That is, the second electrode 102 can be formed simultaneously with the second transfer electrode 82 of the first element unit 3. The second electrode 102 is spaced apart from the semiconductor layer 20 by the same distance as the distance from the semiconductor layer 20 to the second portion 84 of the second transfer electrode 82. Similarly to the electrode (first transfer electrode 81, second transfer electrode 82, and discharge gate electrode 85) of the first element unit 3, the first electrode 101 and the second electrode 102 of the second element unit 4 have a two-layer structure. The third electrode 103 is spaced apart from the semiconductor layer 20 by the same distance as the distance from the semiconductor layer 20 to the first transfer electrode 81. The third electrode 103 may be formed simultaneously with the first electrode 101 or the second electrode 102.

The second element unit 4 has a plurality of insulating layers 95 formed on the semiconductor layer 20. The insulating layer 95 is formed integrally with the insulating layer 90 of the first element unit 3. Each insulating layer 95 is a layer made of, for example, silicon oxide. The silicon oxide is, for example, SiO₂. The plurality of insulating layers 95 electrically separate the first electrode 101, the second electrode 102, and the third electrode 103 from each other. In FIG. 6, only an insulating layer 96 among the plurality of insulating layers 90 is indicated by a dashed double-dotted line for the sake of convenience in description. The insulating layer 96 is formed from between the first electrode 101 and the second electrode 102 to the third electrode 103. The insulating layer 96 is continuous with the insulating layer 91 included in the first element unit 3, and can be formed simultaneously with the insulating layer 91. That is, the insulating layer positioned between the electrode formed as the first layer and the electrode formed as the second layer in the second element unit 4 can be formed simultaneously with the insulating layer positioned between the electrode formed as the first layer and the electrode formed as the second layer in the first element unit 3.

A thickness of a portion 96a of the insulating layer 96 positioned between the first electrode 101 and the second electrode 102 is equal to a thickness of a portion 91a of the insulating layer 91 positioned between the overlapping portion A1 of the first transfer electrode 81 and the overlapping portion A2 of the second transfer electrode 82.

An example of an operation of the solid-state imaging element 1 having the above configuration will be described. In the solid-state imaging element 1, when the light hv is incident on the light receiving part 31, the charges are generated in each pixel of the light receiving part 31. The charges are transferred to the amplifier part 33 by the transfer part 32. In the present embodiment, the charges are transferred along the X direction from a left side to a right side in FIG. 3. Here, the transfer method of the charges will be described with reference to FIG. 3. In the present embodiment, a two-phase driving method is used as the charge transfer method. In the following description, the first transfer regions 71 illustrated in FIG. 3 are referred to as first transfer regions 71A and 71B, and the second transfer regions 72 are referred to as second transfer regions 72A and 72B. In addition, the first transfer electrode 81 over the first transfer region 71A is referred to as a first transfer electrode 81A, and the first transfer electrode 81 over the first transfer region 71B is referred to as a first transfer electrode 81B. Similarly, the second transfer electrode 82 over the second transfer region 72A is referred to as a second transfer electrode 82A, and the second transfer electrode 82 over the second transfer region 72B is referred to as a second transfer electrode 82B.

First, values of voltages P1 applied to the first transfer electrode 81A and the second transfer electrode 82A are increased to appropriate values. The first transfer region 71A has an impurity concentration higher than that of the second transfer region 72A. Thus, in a state where the voltages P1 having the same magnitude are applied to the first transfer electrode 81A and the second transfer electrode 82A, a potential well formed under the first transfer electrode 81A is deeper than a potential well formed under the second transfer electrode 82A. Due to this potential difference, the charges generated in the light receiving part 31 flow from the second transfer region 72A into the first transfer region 71A and are stored in the first transfer region 71A. That is, the first transfer region 71A functions as a storage that stores the charges. The other first transfer regions 71 similarly function as storages. In contrast, since the potential well under the second transfer electrode 82A is shallower than the potential well under the first transfer electrode 81A, the charges do not flow back from the first transfer region 71A to the second transfer region 72A. That is, the second transfer region 72A functions as a barrier that prevents a backflow of the charges. The other second transfer regions 72 similarly function as barriers.

Subsequently, while the values of the voltage P1 applied to the first transfer electrode 81A and the second transfer electrode 82A are decreased, values of voltages P2 applied to the first transfer electrode 81B and the second transfer electrode 82B are increased to appropriate values. As a result, potential wells under the first transfer electrode 81B and the second transfer electrode 82B become deeper than the potential well under the first transfer electrode 81A. In the present embodiment, since the first transfer region 71B has an impurity concentration higher than that of the second transfer region 72B, the potential well under the first transfer electrode 81B is deeper than the potential well under the second transfer electrode 82B. Accordingly, in a state where the value of the voltage P2 is higher than the value of the voltage P1, a depth of the potential well gradually becomes deeper from the first transfer region 71A toward the first transfer region 71B. As a result, the charges stored in the first transfer region 71A pass through the second transfer region 72B and are transferred to the first transfer region 71B. Hereinafter, the charges are transferred in the X direction by repeating the above transfer method also in the other first transfer electrodes 81 and second transfer electrodes 82.

In the solid-state imaging element 1, the charges may be discharged from the charge transfer region 70 to the charge discharge region 75. For example, in a case where excessive charges are present in the charge transfer region 70 due to the incidence of the strong light hv on the light receiving part 31, a part of the charges is discharged to the drain region 76 of the charge discharge region 75. A discharge method of the charges will be described with reference to FIG. 4. When the charges are discharged to the charge discharge region 75, a value of a voltage P3 applied to the discharge gate electrode 85 is increased to an appropriate value. As a result, a potential well under the discharge gate electrode 85 becomes deep (the potential barrier becomes low), and the charges are discharged from the charge transfer region 70 to the charge discharge region 75. In particular, the drain region 76 has an N⁺-type conductivity type and has a high impurity concentration. Thus, when the value of the voltage P3 is increased, a potential well having a relatively large depth is formed in the drain region 76. Thus, in the present embodiment, the charges discharged to the charge discharge region 75 mainly flow into the drain region 76.

The charges transferred in the X direction by the first transfer electrode 81 and the second transfer electrode 82 are sent to the amplifier part 33. In the present embodiment, the charges are sent to the amplifier part 33 for each pixel array extending along the X direction. The electric charge is converted into an analog signal in the amplifier part 33. The analog signal converted by the amplifier part 33 is converted into a digital signal by the conversion part 41. The plurality of digital signals converted by the conversion part 41 are bundled in the multiplexer part 43 and are generated as one digital signal. This digital signal is converted into a differential voltage signal in the output part 44 and is output to the outside.

As described above, in the solid-state imaging element 1, as viewed from the thickness direction of the semiconductor substrate 2, the first transfer electrode 81 includes the overlapping portion A1 overlapping the overlapping portion A2 of the second transfer electrode 82 and the overlapping portion A3 overlapping the overlapping portion A4 of the discharge gate electrode 85. As a result, it is less likely to form gaps between the first transfer electrode 81 and the second transfer electrode 82 and between the first transfer electrode 81 and the discharge gate electrode 85 as viewed from the thickness direction of the semiconductor substrate 2. Thus, in the charge transfer region 70 and the charge discharge region 75, it is possible to suppress generation of a region where charges are trapped, and it is possible to appropriately perform the transfer of the charges and the discharge of the charges. In addition, in the solid-state imaging element 1 in which the first element unit 3 and the second element unit 4 are formed on the single semiconductor substrate 2, in a case where the layer structure of the electrodes included in the first element unit 3 is three or more layers, it is less likely to form the electrodes and the like included in the second element unit 4 with high accuracy. For example, in a case where the layer structure of the electrode included in the first element unit 3 is three or more layers, a step is generated between the first element unit 3 and the second element unit 4, and a resolution when the electrode or the like of the second element unit 4 is formed by photolithography is reduced. In contrast, in the solid-state imaging element 1, the layer structure of the first transfer electrode 81, the second transfer electrode 82, and the discharge gate electrode 85 included in the first element unit 3 is two layers. Thus, the step is hardly generated between the first element unit 3 and the second element unit 4, and it is possible to form an electrode or the like included in the second element unit 4 with high accuracy. As described above, according to the solid-state imaging element 1, appropriate characteristics can be secured.

Further, in the solid-state imaging element 1, as viewed from the Z direction, the first transfer electrode 81 disposed over the first transfer region 71 functioning as the storage overlaps the discharge gate electrode 85, and the second transfer electrode 82 disposed over the second transfer region 72 functioning as the barrier does not overlap the discharge gate electrode 85. As a result, the charges are efficiently discharged from the first transfer region 71 in which more charges are stored than in the second transfer region 72 to the charge discharge region 75, and it is possible to avoid the layer structure of the electrodes (first transfer electrode 81, second transfer electrode 82, and discharge gate electrode 85) included in the first element unit 3 from having a three-layer structure.

Further, in the solid-state imaging element 1, the overlapping portion A1 of the first transfer electrode 81 and the overlapping portion A2 of the second transfer electrode 82 overlap each other, and thus, the generation of the region where the charges are trapped is suppressed. Thus, in the solid-state imaging element 1, it is not necessary to excessively narrow an interval between the first transfer electrode 81 and the second transfer electrode 82 within an XY plane (specifically, an interval between the first transfer electrode 81 and the first portion 83 of the second transfer electrode 82) in order to suppress the generation of the region where the charges are trapped. For the same reason, in the solid-state imaging element 1, it is not necessary to excessively narrow an interval between the first transfer electrode 81 and the discharge gate electrode 85 in the XY plane (specifically, an interval between the first transfer electrode 81 and the first portion 86 of the discharge gate electrode 85) in order to suppress the generation of the region where the charge is trapped. Thus, according to the solid-state imaging element 1, it is possible to suppress short circuits between the first transfer electrode 81 and the second transfer electrode 82 and between the first transfer electrode 81 and the discharge gate electrode 85, and appropriate characteristics can be secured.

Further, in a solid-state imaging element having a three-layer layer structure in which the discharge gate electrode is formed as the first layer, the first transfer electrode is formed as the second layer to overlap a part of the discharge gate electrode, and the second transfer electrode is formed as the third layer to overlap a part of the discharge gate electrode and a part of the first transfer electrode, the first transfer electrode does not have a flat shape. Specifically, the first transfer electrode rides over the discharge gate electrode, and has a hollow due to a thickness of the discharge gate electrode. In a case where the first transfer electrode has the hollow, when the second transfer electrode is formed, a material of the second transfer electrode that has entered the hollow of the first transfer electrode may remain as a residue without being removed by etching. This residue may cause a short circuit between the second transfer electrodes. In contrast, in the solid-state imaging element 1, the first transfer electrode 81 has a flat shape. Thus, in the solid-state imaging element 1, the material of the second transfer electrode 82 hardly remains as the residue on the first transfer electrode 81, and the short circuit between the second transfer electrodes 82 can be suppressed. Accordingly, according to the solid-state imaging element 1, appropriate characteristics can be secured.

In the solid-state imaging element 1, the overlapping portion A2 of the second transfer electrode 82 and the overlapping portion A4 of the discharge gate electrode 85 are positioned on the same side with respect to the first transfer electrode 81 in the thickness direction of the semiconductor substrate 2. According to this configuration, the layer structure of the first transfer electrode 81, the second transfer electrode 82, and the discharge gate electrode 85 included in the first element unit 3 can be formed into two layers with a simple structure.

In the solid-state imaging element 1, the transfer part 32 further includes the insulating layer 91 extending as the same layer between the first transfer electrode 81 and the overlapping portion A2 of the second transfer electrode 82 and between the first transfer electrode 81 and the overlapping portion A4 of the discharge gate electrode 85. According to this configuration, the layer structure of the first transfer electrode 81, the second transfer electrode 82, and the discharge gate electrode 85 included in the first element unit 3 can be formed into two layers with a simple structure.

In the solid-state imaging element 1, the charge discharge region 75 includes the drain region 76, and the discharge gate electrode 85 and the drain region 76 extend in the transfer direction (X direction). According to this configuration, the surplus charges in the charge transfer region 70 can be appropriately discharged to the drain region 76, and an anti-blooming property of the solid-state imaging element 1 can be improved.

In the solid-state imaging element 1, the first element unit 3 includes the amplifier part 33 that converts the charge transferred by the transfer part 32 into the analog signal, and the second element unit 4 includes the conversion part 41 that converts the analog signal into the digital signal. According to this configuration, the solid-state imaging element 1 can convert the analog signal into the digital signal that is not easily influenced by noise.

In the solid-state imaging element 1, the charge transfer region 70 includes the first transfer region 71 and the second transfer region 72 having the impurity concentration different from that of the first transfer region 71, the first transfer electrode 81 is disposed over the first transfer region 71, and the second transfer electrode 82 is disposed over the second transfer region 72. According to this configuration, the two-phase driving method can be used as the charge transfer method in the transfer part 32, and the operation of the first element unit 3 can be realized with a control voltage of a minimum number of phases (two phases).

### [Second Embodiment]

A first element unit 3A included in a solid-state imaging element 1 of a second embodiment is different from the solid-state imaging element 1 of the first embodiment described above in that the semiconductor region 23 is not formed and a three-phase driving method is used as the charge transfer method.

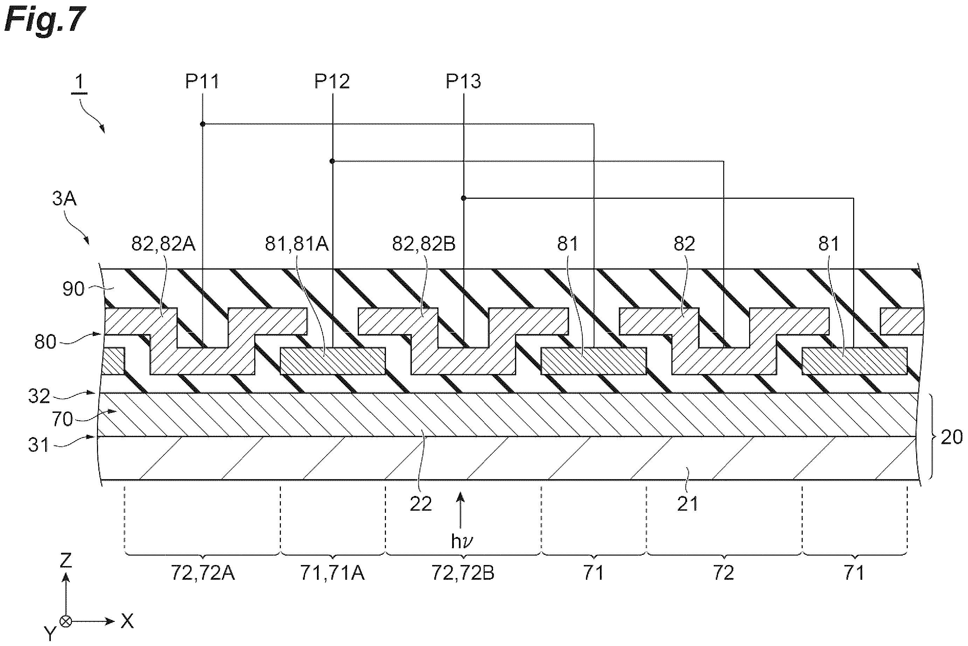

As illustrated in FIG. 7, the semiconductor region 23 is not formed in the semiconductor layer 20. Accordingly, in the first element unit 3A, the impurity concentration of the first transfer region 71 is not different from the impurity concentration of the second transfer region 72. In the second embodiment, the region of the semiconductor regions 22 positioned immediately below the first transfer electrode 81 corresponds to the first transfer region 71, and a region of the semiconductor regions 22 positioned between two the first transfer regions 71 aligned in the X direction corresponds to the second transfer region 72.

A transfer method of charges in the first element unit 3A will be described. In the present embodiment, the three-phase driving method is used as the charge transfer method in the transfer part 32. In the three-phase driving method, charge transfer is performed by applying the same voltage to every three electrodes. In the following description, one first transfer region 71 among the plurality of first transfer regions 71 illustrated in FIG. 7 is referred to as the first transfer region 71A, and the second transfer regions 72 aligned to sandwich the first transfer region 71A in the X direction are referred to as second transfer regions 72A and 72B. In addition, the first transfer electrode 81 over the first transfer region 71A is referred to as a first transfer electrode 81A. Similarly, the second transfer electrode 82 over the second transfer region 72A is referred to as the second transfer electrode 82A, and the second transfer electrode 82 over the second transfer region 72B is referred to as the second transfer electrode 82B.

First, a value of a voltage P11 applied to the second transfer electrode 82A is increased to an appropriate value. As a result, the potential well under the second transfer electrode 82A becomes deep, and the charges generated in the light receiving part 31 are stored in the second transfer region 72A. Subsequently, while the value of the voltage P11 is maintained, a value of a voltage P12 applied to the first transfer electrode 81A is increased to the same level as the value of the voltage P11. As a result, the potential well under the first transfer electrode 81A becomes deep, and the charges stored in the second transfer region 72A also flow into the first transfer region 71A. In this state, the value of the voltage P11 is reduced. As a result, the potential well under the second transfer electrode 82A becomes shallow, and all the charges stored in the second transfer region 72A are transferred to the first transfer region 71A.

Subsequently, while the value of the voltage P12 is maintained, a value of a voltage P13 applied to the second transfer electrode 82B is increased to the same level as the value of the voltage P12. As a result, the potential well under the second transfer electrode 82B becomes deep, and the charges stored in the first transfer region 71A also flow into the second transfer region 72B. In this state, the value of the voltage P12 is reduced. As a result, the potential well under the first transfer electrode 81A becomes shallow, and all the charges stored in the first transfer region 71A are transferred to the second transfer region 72B. Hereinafter, the charges are transferred to the amplifier part 33 by repeating the above-described transfer method also in the other first transfer electrodes 81 and second transfer electrodes 82.

As in the first embodiment, in the second embodiment, the appropriate characteristics of the solid-state imaging element 1 can also be secured. In addition, in the second embodiment, the three-phase driving method is used as the charge transfer method. As a result, in the second embodiment, since it is not necessary to set the impurity concentrations of the first transfer region 71 and the second transfer region 72 to be different from each other (since it is not necessary to form the semiconductor region 23 in the semiconductor region 22), the first element unit 3A can be more easily formed.

### [Third Embodiment]

A first element unit 3B included in a solid-state imaging element 1 of a third embodiment is different from the solid-state imaging element 1 of the first embodiment described above in that the semiconductor region 23 is not formed and that a four-phase driving method is used as the charge transfer method.

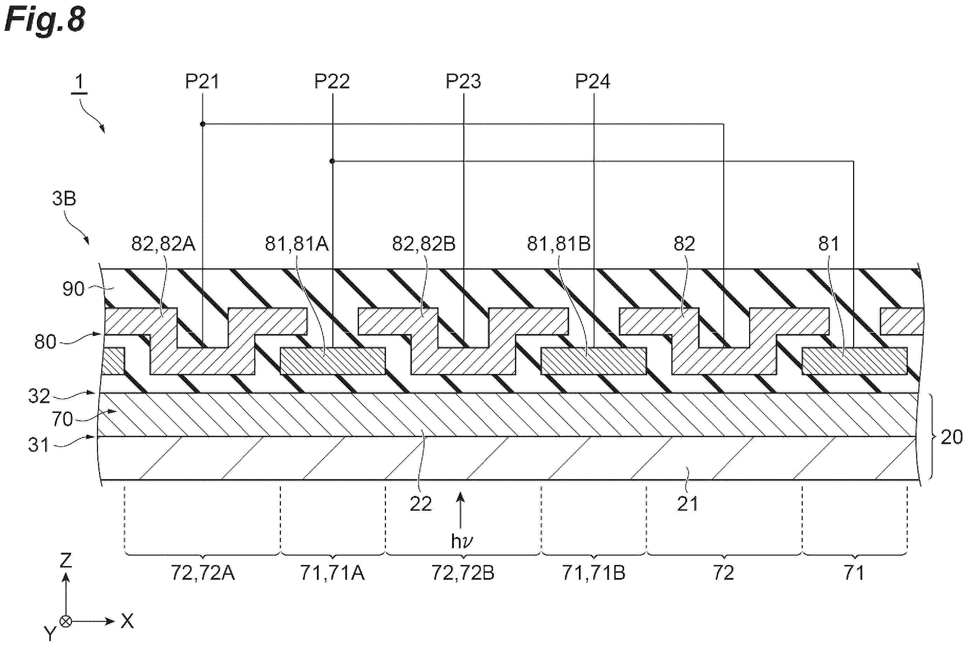

As illustrated in FIG. 8, the semiconductor region 23 is not formed in the semiconductor layer 20. Accordingly, in the first element unit 3B, the impurity concentration of the first transfer region 71 is not different from the impurity concentration of the second transfer region 72. As in the second embodiment, in the third embodiment, the region of the semiconductor regions 22 positioned immediately below the first transfer electrode 81 corresponds to the first transfer region 71, and the region of the semiconductor regions 22 positioned between two first transfer regions 71 aligned in the X direction corresponds to the second transfer region 72.

A transfer method of charges in the first element unit 3B will be described. In the present embodiment, the four-phase driving method is used as the charge transfer method in the transfer part 32. In the four-phase driving method, charge transfer is performed by applying the same voltage for every four electrodes. In the following description, among the plurality of first transfer regions 71 illustrated in FIG. 8, two first transfer regions 71 aligned in the X direction are referred to as the first transfer regions 71A and 71B, and the second transfer regions 72 aligned to sandwich the first transfer region 71A in the X direction are referred to as the second transfer regions 72A and 72B. In addition, the first transfer electrode 81 over the first transfer region 71A is referred to as the first transfer electrode 81A, and the first transfer electrode 81 over the first transfer region 71B is referred to as the first transfer electrode 81B. Similarly, the second transfer electrode 82 over the second transfer region 72A is referred to as the second transfer electrode 82A, and the second transfer electrode 82 over the second transfer region 72B is referred to as the second transfer electrode 82B.

First, a value of a voltage P21 applied to the second transfer electrode 82A and a value of a voltage P22 applied to the first transfer electrode 81A are increased to appropriate values. As a result, the potential wells under the second transfer electrode 82A and the first transfer electrode 81A becomes deep, and the charges generated in the light receiving part 31 are stored in the second transfer region 72A and the first transfer region 71A. Subsequently, while the values of the voltages P21 and P22 are maintained, a value of a voltage P23 applied to the second transfer electrode 82B is increased to the same level as the values of the voltages P21 and P22. As a result, the potential well under the second transfer electrode 82B becomes deep, and the charges stored in the second transfer region 72A and the first transfer region 71A also flow into the second transfer region 72B. In this state, the value of the voltage P21 is reduced. As a result, the potential well under the second transfer electrode 82A becomes shallow, and all the charges stored in the second transfer region 72A are transferred to the first transfer region 71A and the second transfer region 72B.

Subsequently, while the values of the voltages P22 and P23 are maintained, a value of a voltage P24 applied to the first transfer electrode 81B is increased to the same level as the values of the voltages P22 and P23. As a result, the potential well under the first transfer electrode 81B becomes deep, and the charges stored in the first transfer region 71A and the second transfer region 72B also flow into the first transfer region 71B. In this state, the value of the voltage P22 is reduced. As a result, the potential well under the first transfer electrode 81A becomes shallow, and all the charges stored in the first transfer region 71A are transferred to the second transfer region 72B and the first transfer region 71B. Hereinafter, the charges are transferred to the amplifier part 33 by repeating the above-described transfer method also in the other first transfer electrodes 81 and second transfer electrodes 82.

As in the first embodiment, in the third embodiment, the appropriate characteristics of the solid-state imaging element 1 can also be secured. In addition, in the third embodiment, the four-phase driving method is used as the charge transfer method. As a result, in the third embodiment, since it is not necessary to set the impurity concentrations of the first transfer region 71 and the second transfer region 72 to be different from each other (since it is not necessary to form the semiconductor region 23 in the semiconductor region 22), the first element unit 3B can be more easily formed.

### [Modifications]

The present disclosure is not limited to the above embodiments. In the solid-state imaging element 1 of the above embodiments, the P-type and N-type conductivity types may be opposite to those described above. For example, the semiconductor region 22 may have a P-type conductivity type, and the semiconductor region 23 may have a P⁺-type conductivity type. The "P⁺-type" means that a concentration of a P-type impurity is higher than that of the "P-type".

In addition, the overlapping portion A2 of the second transfer electrode 82 and the overlapping portion A4 of the discharge gate electrode 85 may be positioned on the surface 81b side with respect to the first transfer electrode 81 in the thickness direction (Z direction) of the semiconductor substrate 2. In this case, the second portion 84 of the second transfer electrode 82 and the second portion 87 of the discharge gate electrode 85 are positioned to enter between the first transfer electrode 81 and the semiconductor layer 20. In the present modification, in the manufacturing process of the solid-state imaging element 1, the first transfer electrode 81 as the first layer is formed after the second transfer electrode 82 and the discharge gate electrode 85 as the second layers are formed. Accordingly, an order of forming the first layer and the second layer is not limited.

In addition, in the above embodiments, the discharge gate electrode 85 is an electrode to which a voltage P3 having any value can be applied at any timing. That is, in the above embodiments, the discharge gate electrode 85 functions as a shutter electrode that controls a height of a potential barrier between the charge transfer region 70 and the charge discharge region 75. However, the discharge gate electrode 85 may be an electrode to which a constant voltage is constantly applied. In this case, in a case where the amount of charges in the charge transfer region 70 exceeds a predetermined threshold value, the charges are discharged from the charge transfer region 70 to the charge discharge region 75. That is, the drain region 76 functions as an overflow drain region.

In addition, the charges discharged from the charge transfer region 70 to the charge discharge region 75 may be transferred to a region other than the drain region 76 and used without flowing into the drain region 76.

In addition, in the above embodiments, a full frame transfer (FFT) method has been described as an example of the method for transferring the charges generated in the light receiving part 31, but the method for transferring the charges may be, for example, a frame transfer (FT) method, an inter-line (IT) method, or the like. In a case where the full frame transfer method or the frame transfer method is adopted as the charge transfer method, the region of the semiconductor layer 20 constituting the light receiving part 31 also functions as the transfer part 32. In contrast, in a case where the inter-line (IT) method is adopted as the charge transfer method, a region different from the region of the semiconductor layer 20 constituting the light receiving part 31 functions as the transfer part 32.

In addition, in the above embodiments, the back-side incidence type solid-state imaging element 1 in which the light hv is incident from the surface 10b side of the base portion 10 has been described as an example, but the solid-state imaging element 1 may be a front-side incidence type solid-state imaging element in which the light hv is incident from the transfer electrode 80 side. In addition, the base portion 10 may not have the recessed portion 11, and the entire thickness of the base portion 10 may be uniform.

The distance from the semiconductor layer 20 to the first transfer electrode 81 may be different from a distance from the semiconductor layer 20 to the first portion 83 of the second transfer electrode 82. That is, a height of the surface 81b of the first transfer electrode 81 in the Z direction may be different from a height of the surface 83b of the first portion 83. In addition, the distance from the semiconductor layer 20 to the first transfer electrode 81 may be different from a distance from the semiconductor layer 20 to the first portion 86 of the discharge gate electrode 85. That is, the height of the surface 81b of the first transfer electrode 81 in the Z direction may be different from a height of the surface 86b of the first portion 86. As viewed from the Z direction, the width of the gap between the discharge gate electrode 85 and the second transfer electrode 82 in the Y direction may be larger than or equal to the interval between the first transfer electrodes 81 adjacent in the X direction.

The first transfer electrode 81 of the first element unit 3 may be formed at a timing different from that of the first electrode 101 of the second element unit 4. The distance from the semiconductor layer 20 to the first transfer electrode 81 may be different from a distance from the semiconductor layer 20 to the first electrode 101. In addition, the second transfer electrode 82 of the first element unit 3 may be formed at a timing different from that of the second electrode 102 of the second element unit 4. The distance from the semiconductor layer 20 to the second portion 84 of the second transfer electrode 82 may be different from a distance from the semiconductor layer 20 to the second electrode 102. Further, the insulating layer 91 of the first element unit 3 may be formed separately from the insulating layer 96 of the second element unit 4, or may be formed at a timing different from that of the insulating layer 96. The thickness of the portion 91a of the insulating layer 91 may be different from the thickness of the portion 96a of the insulating layer 96.

The second element unit 4 may be configured to transmit the signal to the first element unit 3. For example, the second element unit 4 may include a generation part that generates a drive signal for driving the first element unit 3, and the drive signal generated by the generation part may be transmitted to the first element unit 3. The second element unit 4 may be configured to perform at least one of transmission of a signal to the first element unit 3 and reception of a signal from the first element unit 3.

### Reference Signs List

1 solid-state imaging element
2 semiconductor substrate
3, 3A, 3B first element unit
4 second element unit
31 light receiving part
32 transfer part
33 amplifier part
40 signal processing part
41 conversion part
70 charge transfer region
71, 71A, 71B first transfer region
72, 72A, 72B second transfer region
75 charge discharge region
76 drain region
81, 81A, 81B first transfer electrode
82, 82A, 82B second transfer electrode
85 discharge gate electrode
91 insulating layer
hv light

## Claims

1. A solid-state imaging element comprising:
a semiconductor substrate;
a first element unit formed on the semiconductor substrate; and
a second element unit formed on the semiconductor substrate, wherein
the first element unit includes a light receiving part configured to generate charges in response to incidence of light, and a transfer part configured to transfer the charges,
the second element unit is configured to perform at least one of transmission of a signal to the first element unit and reception of a signal from the first element unit,
the transfer part includes
a first transfer electrode and a second transfer electrode that are disposed over a charge transfer region of the semiconductor substrate, and are aligned in a transfer direction of the charges, and
a discharge gate electrode that is disposed over a charge discharge region of the semiconductor substrate along the charge transfer region,
the first transfer electrode is formed as a first layer,
the second transfer electrode and the discharge gate electrode are formed as second layers different from the first layer,
as viewed from a thickness direction of the semiconductor substrate, the first transfer electrode includes a portion overlapping a part of the second transfer electrode and a portion overlapping a part of the discharge gate electrode, and
as viewed from the thickness direction of the semiconductor substrate, the second transfer electrode is spaced apart from the discharge gate electrode.

2. The solid-state imaging element according to claim 1, wherein the part of the second transfer electrode and the part of the discharge gate electrode are positioned on the same side with respect to the first transfer electrode in the thickness direction of the semiconductor substrate.

3. The solid-state imaging element according to claim 1 or 2, wherein the transfer part further includes an insulating layer extending as the same layer between the first transfer electrode and the part of the second transfer electrode and between the first transfer electrode and the part of the discharge gate electrode.

4. The solid-state imaging element according to any one of claims 1 to 3, wherein
the charge discharge region includes a drain region, and
the discharge gate electrode and the drain region extend in the transfer direction.

5. The solid-state imaging element according to any one of claims 1 to 4, wherein
the first element unit includes an amplifier part configured to convert the charge transferred by the transfer part into an analog signal, and
the second element unit includes a conversion part configured to convert the analog signal into a digital signal.

6. The solid-state imaging element according to any one of claims 1 to 5, wherein
the charge transfer region includes a first transfer region and a second transfer region having an impurity concentration different from an impurity concentration of the first transfer region,
the first transfer electrode is disposed over the first transfer region, and
the second transfer electrode is disposed over the second transfer region.
